Europäisches Patentamt

European Patent Office

Office européen des brevets

(11) Veröffentlichungsnummer: **0 189 529 B1**

(12) **EUROPÄISCHE PATENTSCHRIFT**

(45) Veröffentlichungstag der Patentschrift: **27.12.91**

(51) Int. Cl.5: **H01R 9/26**, H05K 1/14, H05K 1/18

(21) Anmeldenummer: **85113749.7**

(22) Anmeldetag: **29.10.85**

(54) **Mehretagiger Leiterplatten-Klemmenblock.**

(30) Priorität: **29.01.85 DE 3502813**

(43) Veröffentlichungstag der Anmeldung:
**06.08.86 Patentblatt 86/32**

(45) Bekanntmachung des Hinweises auf die
Patenterteilung:
**27.12.91 Patentblatt 91/52**

(84) Benannte Vertragsstaaten:
**AT CH DE FR GB IT LI**

(56) Entgegenhaltungen:
**DE-A- 1 591 434**
**DE-A- 2 910 619**
**DE-B- 2 833 313**
**FR-A- 2 532 811**

(73) Patentinhaber: **C.A. Weidmüller GmbH & Co.**
**Postfach 950 Paderborner Strasse 175**
**W-4930 Detmold 14(DE)**

(72) Erfinder: **Varnholt, Rolf**
**Carl-Miele-Strasse 139**
**W-4830 Gütersloh 1(DE)**

(74) Vertreter: **Loesenbeck, Karl-Otto, Dipl.-Ing. et al**
**Jöllenbecker Strasse 164**
**W-4800 Bielefeld 1(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

## Beschreibung

Die Erfindung betrifft einen mehretagigen Leiterplatten-Klemmenblock mit mindestens einer Stützplatte. Derartige Klemmenblöcke sind beispielsweise aus der DE-PS 28 33 313 bekannt. Für die mechanische Haltgebung haben derartige Klemmenblöcke beispielsweise eine rückwärtige Stützplatte, auf der sich eine obere Klemmenreihe mit dem einen Ende abstützen kann. Derartige Klemmenblöcke können auch seitliche Stützplatten haben, mit denen dem Block sowohl ein seitlicher Zusammenhalt wie auch insbesondere ein mechanischer Halt gegenüber der Leiterplatte gegeben wird, an der der Klemmenblock angeschlossen wird.

Mit der fortlaufenden Miniaturisierung elektrisch/elektronischer Bauelemente entsteht auch das Bedürfnis, immer mehr derartige elektrisch/elektronische Bauelemente auf Leiterplatten unterzubringen.

Der vorliegenden Erfindung liegt die Aufgabe zugrunde, einen mehretagigen Leiterplatten-Klemmenblock der gattungsgemäßen Art zu schaffen, der eine erweiterte Unterbringungs- und Gestaltungsmöglichkeit für elektrisch/elektronische Schaltungen ermöglicht.

Die erfindungsgemäße Lösung besteht darin, daß die Stützplatte zugleich als Leiterplatte ausgebildet ist. Der Stützplatte ist damit über ihre mechanische Haltefunktion hinaus eine weitere Funktion zugeordnet. Bei der Kleinheit neuerer derartiger elektrisch/elektronischer Bauelemente und neue Verarbeitungstechniken für diese können auch auf der relativ kleinen Stützplatte in integrierter Form noch zusätzlich Schaltungen auf der Vorder- und/oder Rückseite untergebracht werden. Dabei besteht einmal die Möglichkeit, daß der Hersteller des mehretagigen Leiterplatten-Klemmenblocks dem Anwender die Anordnung nur lediglich mit der Stützplatte als Leiterplatte zur Verfügung stellt und es dem Anwender überläßt, welche der elektrisch/elektronischen Schaltungen er auf dieser zusätzlichen, von der Stützplatte gebildeten Leiterplatte unterbringen will. Es besteht aber auch die Möglichkeit, dem Anwender schon gleich bestimmte, immer wieder benötigte Schaltungen in integrierter Form zusammen mit dem Klemmenblock zur Verfügung zu stellen, die als Leiterplatte ausgebildete Stützplatte also von vornherein mit entsprechenden Schaltungselementen zu bestücken. In beiden Fällen wird der Anwender in der Gestaltung der elektrisch/elektronischen Schaltungen insgesamt freier, da in jedem Fall die eigentliche Leiterplatte, auf der der Klemmenblock angeschlossen wird, entlastet werden kann. Gemäß einer bevorzugten Ausgestaltungsform ist vorgesehen, mindestens einige Klemmen in der oberen Klemmenreihe des Klemmenblocks mit abgewinkelten Anschlußstiften direkt über der rückwärtigen, als Leiterplatte ausgebildeten Stützplatte des Blockes zu verbinden. Dadurch wird von vornherein auf der eigentlichen Leiterplatte Verdrahtung gespart.

Gemäß einer weiteren Ausgestaltungsform ist die Stützplatte als Tochter-Leiterplatte mit angeformten Anschlußstiften zum Festlegen in der dann als Mutter-Leiterplatte dienenden, den Klemmenblock aufnehmenden Leiterplatte ausgebildet.

In weiterer Ausgestaltung eines derartigen mehretagigen Leiterplatten-Klemmenblockes kann nicht nur die rückwärtige Stützplatte zur Erweiterung der Schaltungsanordnung herangezogen werden, es kann auch die eine oder andere üblicherweise vorgesehene seitliche Stützplatte eines derartigen Klemmenblockes benutzt werden, wozu sich insbesondere auch die neue Oberflächenmontage anbietet, bei der die aufzubringenden Bauelemente unmittelbar auf die Oberfläche der betroffenen Leiterbahnseite montiert werden, dort also sowohl ihre mechanische wie auch elektrische Verbindung erhalten. Das Bauelement und seine Anschlüsse befinden sich dabei dann auf der gleichen Seite der Leiterplatte.

Ein Ausführungsbeispiel eines derartigen mehretagigen Leiterplatten-Klemmenblockes wird nachstehend unter Bezugnahme auf die Zeichnung näher beschrieben.

Es zeigen

Figur 1     eine Vorderansicht eines derartigen Leiterplatten-Klemmenblockes,

Figur 2     eine Seitenansicht des Leiterplatten-Klemmenblockes nach Figur 1,

Figur 3     eine Rückansicht des Leiterplatten-Klemmenblockes nach Figur 1.

Figur 4     eine Draufsicht auf den Leiterplatten-Klemmenblock nach Figur 1.

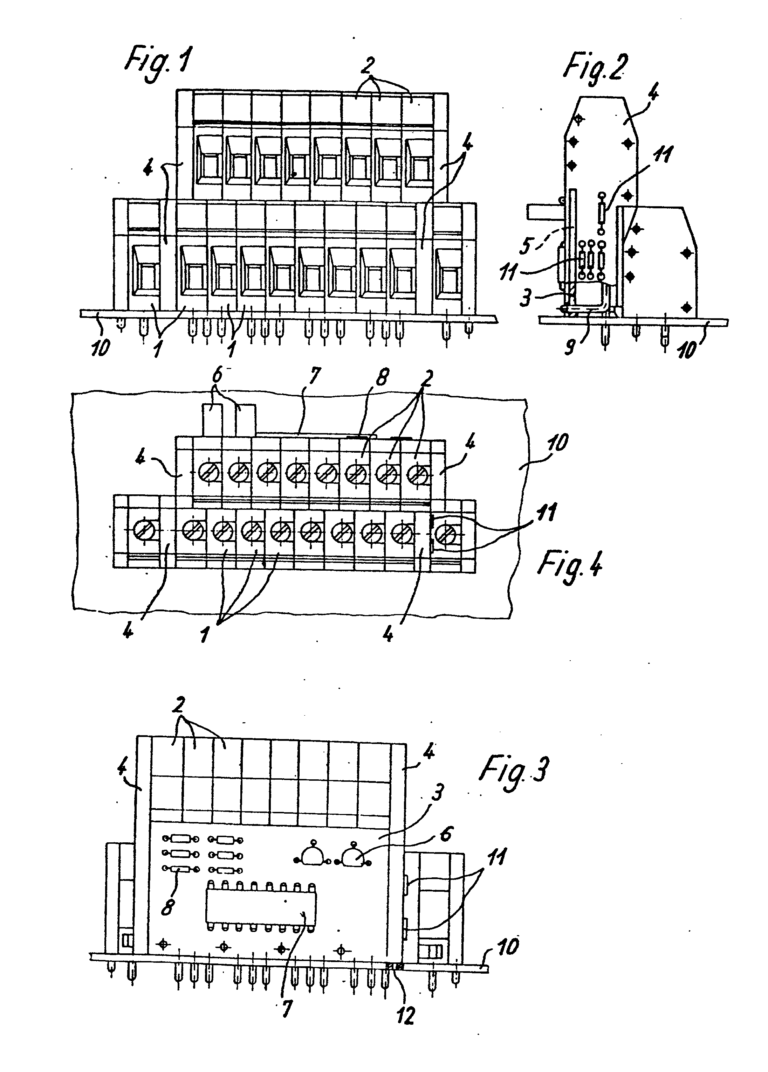

Im dargestellten Ausführungsbeispiel ist ein zweietagiger Klemmenblock gezeigt, der aus einer unteren vorderen Reihe von Klemmen 1 sowie aus einer oberen hinteren Reihe von Klemmen 2 gebildet ist. Die obere Klemmenreihe 2 stützt sich dabei im vorderen Bereich auf dem rückwärtigen oberen Bereich der unteren Klemmenreihe 1 ab und sie stützt sich ferner mit ihrem hinteren unteren Bereich auf einer rückwärtigen Stützplatte 3 ab. Zur Stabilisierung der Klemmenblockbildung sind ferner jeweils mit den angrenzenden Klemmen verrastbare seitliche Stützplatten 4 vorgesehen, die bei stufigem Versatz von unterer Klemmenreihe 1 zu oberer Klemmenreihe 2 gekröpft ausgebildet sein können, wie aus Figur 1 ersichtlich.

Im dargestellten Ausführungsbeispiel ist die rückwärtige Stützplatte 3 beidseitig in entsprechenden Führungsausnehmungen 5 der seitlichen Stützplatten 4 geführt und gehalten.

Wie insbesondere aus Figur 3 ersichtlich, ist die rückwärtige Stützplatte 3 des Leiterplatten-Klemmenblockes selbst als Leiterplatte ausgebildet, beispielsweise als gelochte Leiterplatte. Der Stützplatte 3 ist damit zusätzlich zu ihrer mechanischen Abstützfunktion eine Funktion als Leiterplatte zur Aufnahme elektrischer/elektronischer Bauelemente 6, 7, 8 gegeben. Es besteht dabei die Möglichkeit, herstellerseitig die rückwärtige Stützwand 3 schon gleich mit entsprechenden elektrisch/elektronischen Bauelementen zu bestükken, so daß dem Anwender insoweit schon eine integrierte elektrisch/elektronische Schaltung mit zur Verfügung gestellt wird.

Wie aus Figur 2 ersichtlich, sind im dargestellten Ausführungsbeispiel einige der Anschlußstifte 9 von Klemmen aus der oberen Klemmenreihe 2 abgewinkelt und direkt mit der von der rückwärtigen Stützplatte 3 gebildeten Leiterplatte verbunden. Es kommt insoweit dann zu einer Entlastung der Verdrahtung der eigentlichen, den Klemmenblock tragenden Leiterplatte 10.

Abweichend hiervon besteht auch die Möglichkeit, die rückwärtige Stützplatte 3 als sogenannte "Tochter-Leiterplatte" auszubilden, zu der die Leiterplatte 10 dann die Mutter-Leiterplatte ist. In einem solchen Fall werden an die Stützplatte 3 Anschlußteile zum Einlöten in die Leiterplatte 10 angeformt.

Im dargestellten Ausführungsbeispiel ist ferner beispielshalber aufgezeigt, daß auch zumindest eine der seitlichen Stützplatten 4 des Klemmenblockes noch zur Aufnahme elektrisch/elektronischer Bauelemente als weitere kleine Leiterplatte ausgebildet sein kann. Hierfür bietet sich insbesondere die Oberflächenmontage an. Die Ausgestaltung wäre also so zu treffen, daß die Bauelemente 11 auf dem als Leiterplatte ausgebildeten Bereich der seitlichen Stützplatte 4 unmittelbar auf deren Oberfläche montiert werden. Aus anschlußtechnischen Gründen wird zweckmäßig die seitliche Stützplatte 4 von vornherein als Tochter-Leiterplatte zur Mutter-Leiterplatte 10 ausgebildet, an sie also unterseitig Anschlußteile 12 zum Einlöten in die Leiterplatte 10 angeformt, wie in Figur 3 angedeutet.

## Patentansprüche

1. Mehretagiger Leiterplatten-Klemmenblock mit mindestens einer Stützplatte, **dadurch gekennzeichnet,** daß die Stützplatte (3, 4) zugleich als Leiterplatte ausgebildet ist.

2. Mehretagiger Leiterplatten-Klemmenblock nach Anspruch 1, dadurch gekennzeichnet, daß eine rückwärtige, eine obere Klemmenreihe (2) abstützende Stützplatte (3) als Leiterplatte ausgebildet ist.

3. Mehretagiger Leiterplatten-Klemmenblock nach Anspruch 1 oder 2, dadurch gekennzeichnet, daß mindestens eine seitliche Stützplatte (4) des Klemmenblockes als Leiterplatte ausgebildet ist.

4. Mehretagiger Leiterplatten-Klemmenblock nach Anspruch 1 oder 2, dadurch gekennzeichnet, daß mindestens einige Klemmen der oberen Klemmenreihe (2) mit abgewinkelten Anschlußstiften (9) direkt mit der als Leiterplatte ausgebildeten Stützplatte (3) verbunden sind.

5. Mehretagiger Leiterplatten-Klemmenblock nach einem der Ansprüche 1-3, dadurch gekennzeichnet, daß die Stützplatte (3, 4) als Tochter-Leiterplatte mit angeformten Anschlußstiften (12) zum Festlegen in einer Mutter-Leiterplatte (10) ausgebildet ist.

## Claims

1. A multilayer printed circuit board terminal block comprising at least one support plate characterised in that the support plate (3, 4) is formed at the same time as a printed circuit board.

2. A multilayer printed circuit board terminal block according to claim 1 characterised in that a rearward support plate (3) which supports an upper row of terminals (2) is in the form of a printed circuit board.

3. A multilayer printed circuit board terminal block according to claim 1 or claim 2 characterised in that at least one lateral support plate (4) of the terminal block is in the form of a printed circuit board.

4. A multilayer printed circuit board terminal block according to claim 1 or claim 2 characterised in that at least some terminals of the upper row of terminals (2) are connected with angled connecting pins (9) directly to the support plate (3) which is in the form of a printed circuit board.

5. A multilayer printed circuit board terminal block according to one of claims 1 to 3 characterised in that the support plate (3, 4) is in the form of a daughter printed circuit board with connecting pins (12) formed thereon for fixing in a mother printed circuit board (10).

## Revendications

1. Bloc de bornes à plusieurs étages sur plaquettes de circuits imprimés avec au moins une plaque de soutien, caractérisé en ce que la plaque de soutien (3, 4) est également une plaquette de circuits imprimés.

2. Bloc de bornes à plusieurs étages sur plaquettes de circuits imprimés selon la revendication 1, caractérisé en ce qu'une plaque de soutien arrière (3), supportent une série supérieure de bornes (2), fait fonction de plaquette de circuits imprimés.

3. Bloc de bornes à plusieurs étages sur plaquettes de circuits imprimés selon la revendication 1 ou 2, caractérisé en ce qu'au moins une plaque de soutien latérale (4) du bloc de bornes fait fonction de plaquette de circuits imprimés.

4. Bloc de bornes à plusieurs étages sur plaquettes de circuits imprimés selon la revendication 1 ou 2, caractérisé en ce qu'au moins certaines des bornes de la série supérieure (2) sont connectées directement à la plaque de soutien (3) faisant fonction de plaquette de circuits imprimés par l'intermédiaire de broches de raccordement cintrées.

5. Bloc de bornes à plusieurs étages sur plaquettes de circuits imprimés selon l'une des revendications 1 à 3, caractérisé en ce que le plaque de soutien (3, 4) fait fonction de plaquette auxiliaire, équipée de broches de raccordement (12) pour sa fixation à une plaquette principale (10).

Fig. 1

Fig. 2

Fig. 4

Fig. 3